# EUROPEAN PATENT APPLICATION

(11) **EP 4 807 380 A2**
(43) Date of publication of application: **16.09.2026**
(21) Application number: 25850886.0
(22) Date of filing: 01.10.2025
(51) Int. Cl.: G01R 31/392, G01R 31/396, G01R 31/367, G01R 31/382

(54) **BATTERY DIAGNOSIS DEVICE AND METHOD THEREFOR**

(71) Applicant: LG Energy Solution, Ltd., Seoul 07335 (KR)
(72) Inventor: LEE, Seung Hyun, Daejeon 34122 (KR); LEE, Bom Jin, Daejeon 34122 (KR)
(74) Representative: Plasseraud IP
(86) International application number: PCT/IB2025/059867
(87) International publication number: WO 2026/033504

(57) **Abstract**

A battery diagnosis device according to an embodiment of this document includes a memory in which one or more instructions are stored and a processor configured to execute the one or more instructions, in which the processor is configured to acquire time series data related to a target battery for a designated duration, and diagnose a state of the target battery based on a database for diagnosing whether a state of a battery is an abnormal state and the time series data, and the time series data has a format corresponding to the database.

## Description

### TECHNICAL FIELD

### Cross-reference to Related Applications

This application claims priority from Korean Patent Application No. 10-2024-0106854, filed on August 9, 2024, the disclosure of which is incorporated by reference herein.

### Technical Field

Embodiments disclosed in this document relate to a battery diagnosis device and battery diagnosis method.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Recently, the scope of use of the secondary batteries has expanded to include a power source for electric vehicles, and the secondary batteries are attracting attention as a next-generation energy storage medium.

When a defect of the battery occurs, such as lithium deposition, a dangerous situation (e.g., fire) may occur, and thus it is necessary to quickly and accurately determine the defect of the battery, that is, an abnormal state of the battery. Therefore, various studies are being conducted on ways to determine the abnormal state of the battery before a dangerous situation occurs.

### DISCLOSURE OF THE INVENTION

### TECHNICAL PROBLEM

Embodiments provide a battery diagnosis device and battery diagnosis method for determining a state of a target battery and/or an abnormality type of the target battery based on time series data acquired from the target battery.

Embodiments provide a battery diagnosis device and battery diagnosis method for quickly and accurately identifying the state of a target battery and/or an abnormality type of the target battery by converting time series data of the target battery into data visually representing the time series data and determining the state of the target battery and/or the abnormality type of the target battery based on whether or not the data visually representing the time series data matches a graph contained in a database.

The technical problems of the present invention are not limited to the technical problems mentioned above, and other technical problems that are not mentioned may be clearly understood by those skilled in the art from the descriptions below.

### TECHNICAL SOLUTION

A battery diagnosis device according to an embodiment of this document includes a memory in which one or more instructions are stored and a processor configured to execute the one or more instructions, in which the processor is configured to acquire time series data related to a target battery for a designated duration and diagnose a state of the target battery based on a database for diagnosing whether a state of a battery is an abnormal state and the time series data, and the time series data has a format corresponding to the database.

In an embodiment, the processor may be configured to diagnose the state of the target battery based on a comparison between the database and the time series data.

In an embodiment, the processor may be configured to generate a graph representing at least one of a voltage, a current, a temperature, a resistance, a state of charge (SOC), and a state of health (SOH) of the battery included in the time series data, and any combination thereof, based on identifying the at least one of the voltage, the current, the temperature, the resistance, the SOC, the SOH, and any combination thereof.

In an embodiment, the processor may be configured to diagnose whether the state of the target battery is an abnormal state based on whether the graph and the database match.

In an embodiment, the processor may be configured to identify that the state of the target battery is the abnormal state based on the fact that the graph and the database match.

In an embodiment, the processor may be configured to identify an abnormality type of the state of the target battery based on the fact that the graph and the database match.

In an embodiment, the processor may be configured to identify that the state of the target battery is a normal state based on the fact that the graph and the database do not match.

In an embodiment, the database may include an abnormal graph in which reference time series data corresponding to an abnormal state of the battery is represented.

In an embodiment, the processor may be configured to identify whether the time series data matches the database based on a feature point of the abnormal graph.

In an embodiment, the battery may include at least one of a battery cell, a battery pack, a battery module, and any combination thereof.

A battery diagnosis method according to an embodiment of this document includes an operation of acquiring, by a processor, time series data related to a target battery for a designated duration and an operation of diagnosing, by the processor, a state of the target battery based on a database for diagnosing whether a state of a battery is an abnormal state and the time series data, in which the time series data has a format corresponding to the database.

The battery diagnosis device according to an embodiment may include an operation of diagnosing the state of the target battery based on a comparison between the database and the time series data.

The battery diagnosis device according to an embodiment may include an operation of generating a graph representing at least one of a voltage, a current, a temperature, a resistance, a state of charge (SOC), and a state of health (SOH) of the battery included in the time series data, and any combination thereof, based on identifying the at least one of the voltage, the current, the temperature, the resistance, the SOC, the SOH, and any combination thereof.

The battery diagnosis device according to an embodiment may include an operation of diagnosing whether the state of the target battery is an abnormal state based on whether the graph and the database match.

The battery diagnosis device according to an embodiment may include an operation of identifying that the state of the target battery is the abnormal state based on the fact that the graph and the database match.

### ADVANTAGEOUS EFFECTS

The present technology can determine the state of the target battery and/or the abnormality type of the target battery based on time series data acquired from the target battery.

In addition, the present technology can quickly and accurately identify the state of the target battery and/or the abnormality type of the target battery by converting the time series data of the target battery into data that is visually represented and determining the state of the target battery and/or the abnormality type of the target battery based on whether or not it matches a graph contained in a database.

In addition, various effects that are directly or indirectly identified through this document can be provided.

### BRIEF DESCRIPTION OF THE DRAWINGS

FIG. 1 illustrates an example of a block diagram illustrating a battery pack, in a battery diagnosis device and battery diagnosis method according to an embodiment of this document.
FIG. 2a illustrates an example of a block diagram illustrating a configuration of a battery diagnosis device according to an embodiment of this document.
FIG. 2b illustrates an example in which a battery diagnosis device according to an embodiment of this document establishes a communication link with an electronic device.
FIG. 3 illustrates an example of a flowchart related to a battery diagnosis method according to an embodiment of this document.
FIGS. 4a to 4c illustrate an example of an abnormal graph represented when the state of a battery is an abnormal state in an embodiment of this document.
FIG. 5 illustrates an example of a flowchart related to a battery diagnosis method according to an embodiment of this document.
FIG. 6 illustrates an example of a block diagram illustrating a hardware configuration of a computing system that performs a battery diagnosis method, in a battery diagnosis device and battery diagnosis method according to an embodiment of this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

According to an embodiment, the method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

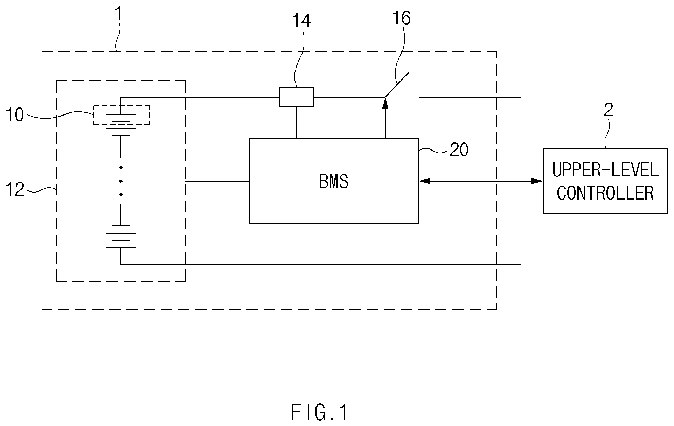

Hereinafter, embodiments of this document will be described in detail with reference to FIGS. 1 to 6.

FIG. 1 illustrates an example of a block diagram showing a battery pack, in a battery diagnosis device and battery diagnosis method according to an embodiment of this document.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be, but is not limited to, an electric vehicle (EV).

According to an embodiment, the battery unit 12 may include at least one battery cell 10 that is chargeable and dischargeable. Here, the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may acquire information related to the battery unit 12. According to an embodiment, the sensor unit 14 may acquire values (or information) related to a state of each of the battery units 12 or battery cells 10. In an embodiment, the values related to the state may include one or more values for a voltage, a current, a resistance, a state of charge (SOC), a state of health (SOH), or a temperature of the battery cell, or a combination thereof.

According to an embodiment, the sensor unit 14 may provide information on each of the plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharging and overdischarging, etc. by monitoring the voltage, current, temperature, etc. of the battery pack 1. For example, the battery management system 20 is an interface that receives values acquired by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of a relay or contactor, etc.

According to an embodiment, an operation of the battery management system 20 may be performed by a battery management system (BMS) in a vehicle, and may also be performed in various devices such as a server, a cloud, a charger, or a charger/discharger.

An upper-level controller 2 may transmit a control signal for the plurality of battery units 12 to the battery management system 20. Accordingly, the operation of the battery management system 20 may be controlled based on a signal applied from the upper-level controller 2.

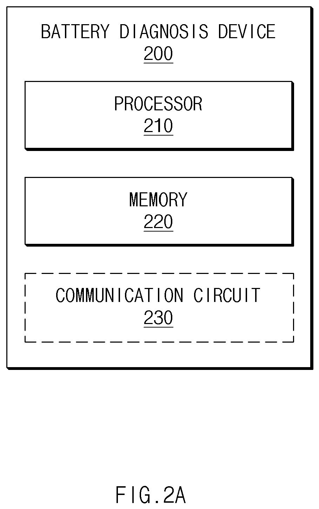

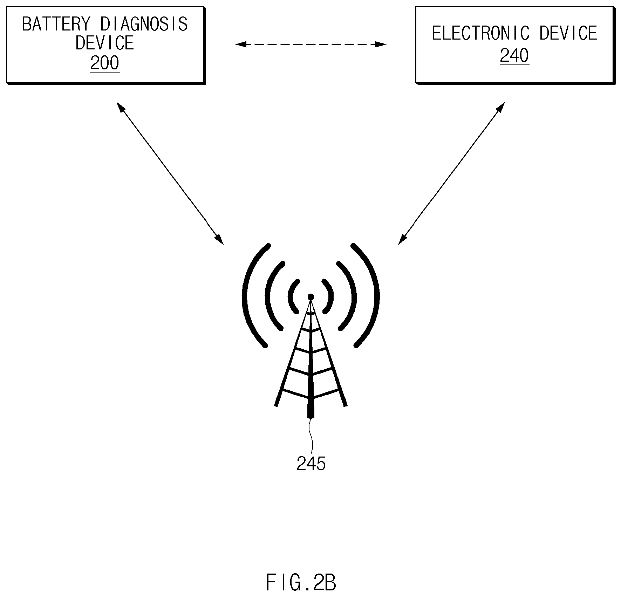

According to an embodiment, the battery management system 20 may include a battery diagnosis device 200 of FIG. 2. According to another embodiment, the battery management system 20 may be a different system from the battery diagnosis device 200 of FIG. 2. That is, the battery diagnosis device 200 of FIG. 2 may be included in the battery pack 1 or may be configured as another device external to the battery pack 1. Hereinafter, for convenience of description, the description will be made on the assumption that the battery diagnosis device 200 is configured as another device external to the battery pack 1. In addition, the operation of the battery diagnosis device 200 described below may be performed by a BMS in the vehicle, and may also be performed by various devices such as a server, a cloud, a charger, or a discharger.

FIG. 2a illustrates an example of a block diagram illustrating the configuration of a battery diagnosis device according to an embodiment of this document.

Referring to FIG. 2a, the battery diagnosis device 200 may include a memory 203 and a processor 205. However, it is not limited thereto, and other components may be further included in the battery diagnosis device 200, two or more components may be integrated into one component, or one component may be divided into two or more components.

A battery diagnosis device 200 according to an embodiment may include a processor 210 and a memory 220. According to the embodiment, the battery diagnosis device 200 may further include a communication circuit 230. The processor 210, the memory 220, or the communication circuit 230 may be electrically and/or operably coupled with each other by an electronical component including a communication bus.

Hereinafter, operably coupling pieces of hardware with each other may include a direct connection and/or an indirect connection between pieces of hardware being established in a wired manner and/or wirelessly, such that a second piece of hardware is controlled by a first piece of hardware among the pieces of hardware.

Although hardware components included in the battery diagnosis device 200 of FIG. 2a are illustrated in different blocks, embodiments are not limited thereto. For example, some of the pieces of hardware of FIG. 2a may be included in a single integrated circuit including a system on a chip (SoC). The type and/or number of pieces of hardware included in the battery diagnosis device 200 is not limited to that shown in FIG. 2a. For example, the battery diagnosis device 200 may include only some pieces of the hardware shown in FIG. 2a.

The battery diagnosis device 200 according to an embodiment may include hardware for processing data based on one or more instructions. The hardware for processing data may include the processor 210. For example, hardware for processing data may include an arithmetic and logic unit (ALU), a floating point unit (FPU), a field programmable gate array (FPGA), a central processing unit (CPU), and/or an application processor (AP). For example, the processor 210 may have a single-core processor architecture or a multi-core processor architecture having dual cores, quad cores, hexa cores, or octa cores.

The memory 220 of the battery diagnosis device 200 according to an embodiment may include hardware components for storing data and/or instructions input and/or output to and from the processor 210 of the battery diagnosis device 200.

For example, the memory 220 may include a volatile memory including a random-access memory (RAM) and/or a non-volatile memory including a read-only memory (ROM).

For example, the volatile memory may include at least one of dynamic RAM (DRAM), static RAM (SRAM), cache RAM, pseudo SRAM (PSRAM), and any combination thereof.

For example, the non-volatile memory may include at least one of a programmable ROM (PROM), an erasable PROM (EPROM), an electrically erasable PROM (EEPROM), a flash memory, a hard disk, a compact disc, a solid state drive (SSD), an embedded multi-media card (eMMC), and any combination thereof.

For example, at least one instruction (or command) indicating operations and/or actions to be performed on data by the processor 210 of the battery diagnosis device 200 may be stored in the memory 220 of the battery diagnosis device 200. A set of one or more instructions may be referred to as a program, firmware, operating system, process, routine, subroutine, and/or application. Hereinafter, the installation of an application in the battery diagnosis device 200 may mean that at least one instruction provided in the form of an application is stored in the memory 220, and that the application is stored in an executable format (e.g., a file having an extension designated by an operating system of the battery diagnosis device 200) by the processor 210 of the battery diagnosis device 200.

The communication circuit 230 of the battery diagnosis device 200 according to an embodiment may include a hardware component for supporting transmission and/or reception of signals between the battery diagnosis device 200 and an external electronic device. For example, the communication circuit 230 may include at least one of a modem, an antenna, an optic/electronic (O/E) converter, and any combination thereof. For example, the communication circuit 230 may support transmission and/or reception of signals based on various types of protocols, including at least one of Ethernet, local area network (LAN), wide area network (WAN), wireless fidelity (WiFi), Bluetooth, Bluetooth low energy (BLE), ZigBee, long term evolution (LTE), 5G new radio (NR), controller area network (CAN), local interconnect network (LIN), and any combination thereof. However, examples related to the communication circuit 230 are not limited to those described above.

The battery diagnosis device 200 according to an embodiment may include the memory 220 in which one or more instructions are stored and the processor 210 that executes the one or more instructions.

In an embodiment, the processor 210 may acquire time series data related to a target battery for a designated duration. For example, the time series data may include at least one of the voltage of the target battery, the current of the target battery, the temperature of the target battery, the resistance of the target battery, the state of charge (SOC) of the target battery, the state of health (SOH) of the target battery, and any combination thereof.

In an embodiment, the processor 210 may identify the voltage of the target battery for the designated duration. For example, the processor 210 may identify at least one of the voltage, the current, the temperature, the resistance, the SOC, the SOH, and any combination thereof of the target battery for the designated duration. Hereinafter, an example of identifying the state of the target battery and/or the abnormality type of the target battery using the voltage of the target battery will be described. However, when the battery diagnosis device 200 identifies the state of the target battery, the battery diagnosis device 200 may use at least one of the voltage, the current, the temperature, the resistance, the SOC, the SOH, and any combination thereof of the target battery, including the voltage of the target battery. For convenience of description, an example of identifying the state of the target battery and/or the abnormality type of the target battery using the voltage of the target battery will be described, but embodiments of this document are not limited thereto. Hereinafter, the target battery may include the battery pack 1, the battery unit 12, and/or the battery cell 10 described in FIG. 1. In addition, the data described below may be included in the time series data.

For example, the processor 210 may acquire data visually representing the voltage of the target battery based on identifying the voltage of the target battery. The processor 210 may acquire data visually representing the voltage of the target battery based on identifying the voltage of the target battery. For example, data visually representing the voltage of the target battery may have a format corresponding to a database. For example, data visually represent the voltage of the target battery may have a format that is comparable to the database. For example, data visually representing the voltage of the target battery may include at least one of a graph, a table, a chart, or any combination thereof. However, examples of data visually representing the voltage of the target battery are not limited to those described above.

For example, the processor 210 may acquire a graph representing the voltage of the target battery based on identifying the voltage of the target battery. For example, a graph representing the voltage of the target battery may include a graph representing the voltage of the target battery over time. For example, a first axis included in a graph (e.g., the x-axis) may represent time. For example, a second axis (e.g., the y-axis) included in the graph may represent a value corresponding to the voltage of the target battery.

In an embodiment, the processor 210 may diagnose the state of the target battery based on a database for diagnosing whether the state of the battery is an abnormal state and the voltage of the target battery. For example, the database for diagnosing whether the battery is an abnormal state may be stored in the memory 220 or may be acquired from an electronic device different from the battery diagnosis device 200. For example, when the battery diagnosis device 200 acquire the database from an electronic device different from the battery diagnosis device 200, the database may be acquired through the communication circuit 230. For example, the database may include an abnormal graph in which the voltage corresponding to an abnormal state of the battery is represented. For example, the abnormal graph may include a graph representing a pattern of voltages identified when the state of the battery is an abnormal state.

For example, the processor 210 of the battery diagnosis device 200 may compare the database with the voltage of the target battery. For example, the processor processor 210 may diagnose the state of the battery based on a comparison between the database and the voltage of the target battery. For example, at least one of the target battery, the battery, and any combination thereof may include at least one of the battery cell, the battery pack, the battery module, and any combination thereof. However, examples of at least one of the target battery, battery, and any combination thereof are not limited to those described above.

For example, the processor 210 may generate a graph representing the voltage of the target battery based on identifying the voltage of the target battery. For example, the processor 210 may compare a graph representing the voltage of the target battery with the database. For example, the processor 210 may diagnose the state of the target battery based on a comparison between a graph representing the voltage of the target battery and the database.

For example, the processor 210 may identify whether the graph representing the voltage of the target battery and the database match. For example, the processor 210 may diagnose the state of the target battery based on whether the graph representing the voltage of the target battery and the database match.

For example, the matching may include cases where all or part of the data time sections match when comparing first data with second data. For example, the matching may include cases where, when comparing the first data and the second data, all or part of the data time sections fall within a designated error range even if they do not match. For example, the matching may include cases where, when comparing the first data with the second data, at least some of first representative values contained in the first data and second representative values contained in the second data match.

In an embodiment, the processor 210 may identify that the graph representing the voltage of the target battery and the database match. For example, the processor 210 may identify that the state of the target battery is an abnormal state based on the fact that the graph representing the voltage of the target battery and the database match. For example, the processor 210 may identify an abnormality type of the state of the target battery based on the fact that the graph representing the voltage of the target battery and the database match.

For example, the fact that the graph representing the voltage of the target battery and the database match may include a fact that the abnormal graph contained in the database and the graph representing the voltage of the target battery match. For example, the fact that the graph representing the voltage of the target battery and the database match may include a fact that a pattern represented by the abnormal graph contained in the database and a pattern represented by the graph representing the voltage of the target battery match.

In an embodiment, the processor 210 may identify that the state of the target battery is a normal state based on the fact that the graph representing the voltage of the target battery the database do not match. For example, the fact that the graph representing the voltage of a target battery and the database do not match may include a fact that the abnormal graph contained in the database and a graph representing the voltage of the first battery do not match. For example, the fact that the graph representing the voltage of a target battery and the database do not match may include a fact that a pattern represented by the abnormal graph contained in the database and a pattern represented by the graph representing the voltage of the target battery do not match.

For example, the processor 210 may identify whether the voltage of the target battery matches the database based on the feature points of the abnormal graph contained in the database. For example, the processor 210 may identify whether the graph representing the voltage of the target battery matches the database based on the feature points of the abnormal graph contained in the database.

For example, the processor 210 may identify a first displacement value at a first point where displacement occurs in the abnormal graph, and a second displacement value at a second point different from the first point. For example, the processor 210 may identify whether the state of the target battery is an abnormal state based on whether a voltage difference exceeding a difference between the first displacement value and the second displacement value is identified in the graph representing the voltage of the target battery. An example of identifying the state of the target battery using the difference between the first displacement value and the second displacement value is an example that can be used when diagnosing the state of the target battery, and is not limited to that described above.

As described above, the battery diagnosis device 200 according to an embodiment may identify the state of the target battery and/or the abnormality type of the target battery based on the data visually representing the voltage of the target battery and the database. The battery diagnosis device 200 may quickly and accurately identify the abnormal state of the target battery by identifying the abnormal state of the target battery and/or the abnormality type of the target battery using the data visually represent the voltage of the target battery.

FIG. 2b illustrates an example in which a battery diagnosis device according to an embodiment of this document establishes a communication link with an electronic device.

Referring to FIG. 2b, the battery diagnosis device 200 according to an embodiment may establish a communication link with an electronic device 240. For example, the battery diagnosis device 200 may establish the communication link with the electronic device 240 through the communication circuit 230. For example, the battery diagnosis device 200 may establish the communication link with the electronic device 240 through a base station 245.

The battery diagnosis device 200 that has established the communication link with the electronic device 240 may receive a database from the electronic device 240. For example, the battery diagnosis device 200 may diagnose whether the state of the target battery is an abnormal state based on the database received from the electronic device 240.

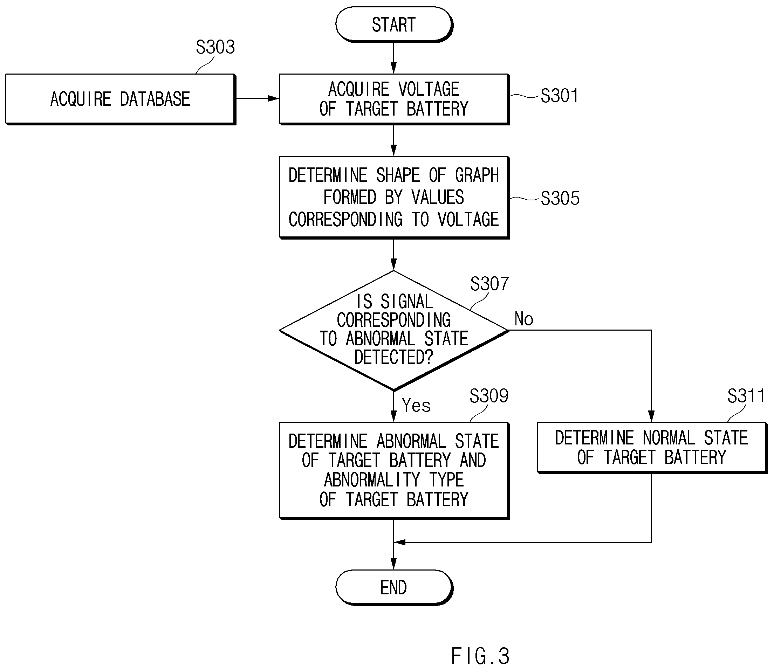

FIG. 3 illustrates an example of a flowchart related to a battery diagnosis method according to an embodiment of this document.

Hereinafter, it is assumed that the battery diagnosis device 200 of FIG. 2 performs the process of FIG. 3. In addition, in the description of FIG. 3, it may be understood that the operation described as being performed by the device is controlled by the processor 210 of the battery diagnosis device 200.

At least one of the operations of FIG. 3 may be performed by the battery diagnosis device 200 of FIG. 2. At least one of the operations of FIG. 3 may be controlled by the processor 210 of FIG. 2. Each of the operations of FIG. 3 may be sequentially performed, but they are not necessarily performed sequentially. For example, the order of each of the operations may be changed, and at least two operations may be performed in parallel.

The battery diagnosis method according to an embodiment may include, in operation S301, an operation of acquiring a voltage of a target battery.

For example, the battery diagnosis method may include an operation of acquiring data visually representing the voltage of the target battery based on acquiring the voltage of the target battery. For example, the data visually representing the voltage of the target battery may include a graph formed by values corresponding to the voltage described in operation S305.

In operation S303, the battery diagnosis method according to an embodiment may include an operation of acquiring a database.

For example, the battery diagnostic method may include an operation of acquiring the database from the electronic device 240 and/or the memory 220.

In operation S305, the battery diagnosis method according to an embodiment may include an operation of determining the shape of a graph formed by values corresponding to the voltage.

For example, the battery diagnosis method may include an operation of determining the shape of a graph formed by values corresponding to the voltage of a target battery based on identifying the voltage of the target battery. For example, the graph formed by values corresponding to the voltage of the target battery may be included in the data visually representing the voltage of the target battery described in FIG. 1.

For example, the battery diagnosis method may include an operation of determining whether the shape of the graph formed by values corresponding to the voltage of the target battery is identical to the shape of an abnormal graph contained in the database.

The battery diagnosis method according to an embodiment may include an operation of analyzing and determining an abnormal voltage of the target battery. For example, the battery diagnosis method may include an operation of performing a singular value decomposition (SVD). For example, the battery diagnosis method may include an operation of reconstructing principal components acquired based on the SVD. For example, the battery diagnosis method may include an operation of determining the shape of a voltage signal acquired by restoring the principal components. For example, the battery diagnosis method may include an operation of identifying whether a signal corresponding to an abnormal state is detected based on the shape of the voltage signal acquired by restoring the principal components. Hereinafter, an operation of identifying whether the signal corresponding to an abnormal state is detected will be described.

In operation S307, the battery diagnosis method according to an embodiment may include an operation of identifying whether the signal corresponding to the abnormal state is detected.

When the signal corresponding to the abnormal state is detected (Yes in operation S307), in operation S309, the battery diagnosis method according to an embodiment may include an operation of determining an abnormal state of the target battery and an abnormality type of the target battery.

The battery diagnosis method according to an embodiment may include an operation of identifying the abnormality type of the target battery based on each of graphs contained in the database. For example, the battery diagnosis method may identify that the abnormality type of the target battery is a first type based on the fact that a first graph contained in the database and the shape of the graph formed by the voltage of the target battery match.

As described above, the battery diagnosis method according to an embodiment may include an operation of identifying the abnormality type matching the graph contained in the database, and identifying the abnormality type of the target battery based on identifying the graph formed by the voltage of the target battery matching the graph contained in the database.

The battery diagnosis method according to an embodiment may include an operation of performing noise filtering on the time series data acquired from the target battery to determine the abnormal state of the target battery and the abnormality type of the target battery. For example, a signal filtered by noise filtering may include a result value of entropy estimation. For example, the signal filtered by noise filtering may include a case where it has a very large peak value only when the displacement value of the x-axis is 0 and close to zero for other x-axis displacement values, like the Dirac delta function. For example, the signal filtered by noise filtering may include the above-described feature points.

When the signal corresponding to the abnormal state is not detected (No in operation S307), in operation S311, the battery diagnosis method according to an embodiment may include an operation of determining a normal state of the target battery.

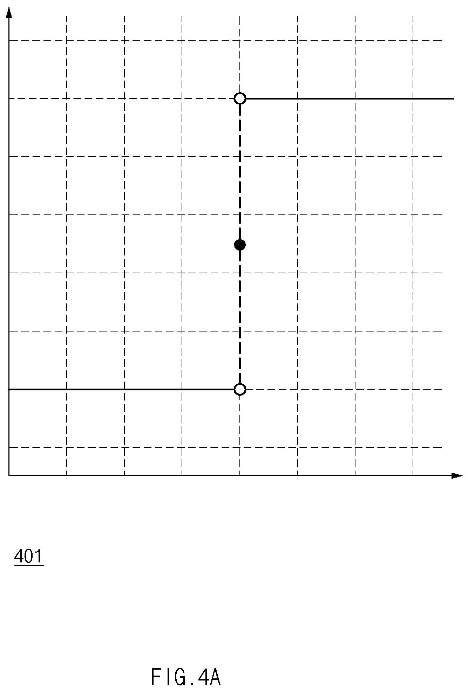

FIGS. 4a to 4c illustrate an example of an abnormal graph represented when the state of a battery is an abnormal state in an embodiment of this document.

Referring to FIG. 4a, a first graph 401 may include an abnormal graph represented when the state of a battery is an abnormal state. For example, the first graph 401 may be included in the database and used when diagnosing the state of the target battery.

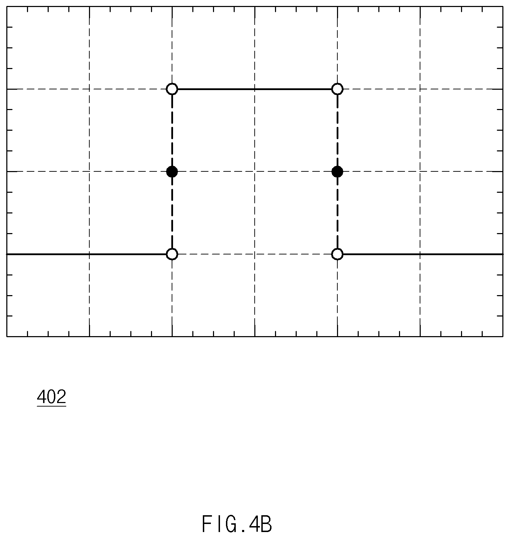

Referring to FIG. 4b, a second graph 402 may include an abnormal graph represented when the state of the battery is an abnormal state. For example, the second graph 402 may be included in the database and used when diagnosing the state of the target battery.

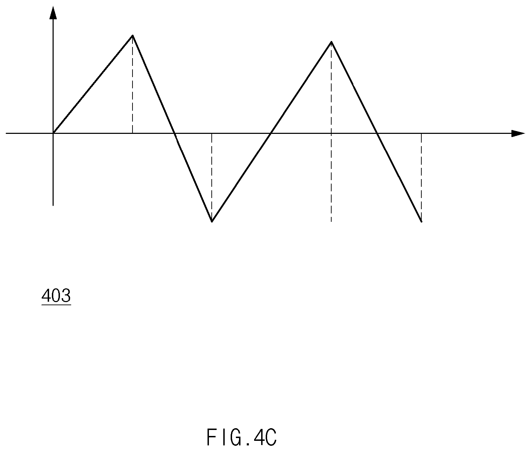

Referring to FIG. 4c, a third graph 403 may be included in the abnormal graph represented when the state of the battery is an abnormal state. For example, the third graph 403 may be included in the database and used when diagnosing the state of the target battery

However, examples of abnormal graphs included in the database are not limited to the first graph 401, the second graph 402, and the third graph 403.

The processor 210 of the battery diagnosis device 200 according to an embodiment may diagnose the state of the target battery based on at least one of the first graph 401, second graph 402, and third graph 403 included in the database, and any combination thereof. For example, the processor may diagnose the state of the target battery based on whether at least one of the first graph 401, the second graph 402, the third graph 403, and any combination thereof matches the graph representing the voltage of the target battery.

For example, the processor 210 of the battery diagnosis device 200 may diagnose the state of the target battery based on the feature points identified in each of the first graph 401, the second graph 402, and the third graph 403.

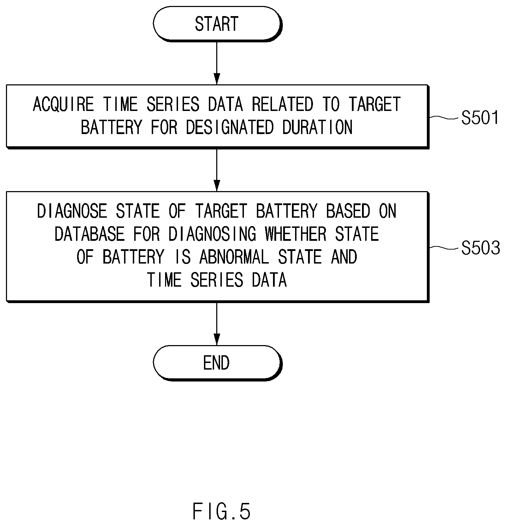

FIG. 5 illustrates an example of a flowchart related to a battery diagnosis method according to an embodiment of this document.

Hereinafter, it is assumed that the battery diagnosis device 200 of FIG. 2 performs the process of FIG. 5. In addition, in the description of FIG. 5, the operation described as being performed by the device may be understood as being controlled by the processor 210 of the battery diagnosis device 200.

At least one of the operations of FIG. 5 may be performed by the battery diagnosis device 200 of FIG. 2. At least one of the operations of FIG. 5 may be controlled by the processor 210 of FIG. 2. Each of the operations of FIG. 5 may be performed sequentially, but they are not necessarily performed sequentially. For example, the order of each of the operations may be changed, and at least two operations may be performed in parallel.

In operation S501, the battery diagnosis method according to an embodiment may include an operation of acquiring time series data related to a target battery for a designated duration.

For example, the time series data related to the target battery may include at least one of a voltage of the target battery, a current of the target battery, a temperature of the target battery, a resistance of the target battery, a SOC of the target battery, a SOH of the target battery, and any combination thereof. Hereinafter, for convenience of description, an example of using the voltage of the target battery will be described. However, the embodiments of this document are not limited to using the voltage of the target battery.

For example, the battery diagnosis method may include an operation of generating a graph representing the voltage of the target battery based on identifying the voltage of the target battery for a designated duration.

In operation S503, the battery diagnosis method according to an embodiment may include an operation of diagnosing a state of the target battery based on a database for diagnosing whether a state of the battery is an abnormal state and a voltage of the target battery.

For example, the battery diagnosis method may include an operation of diagnosing the state of the target battery based on a comparison between the database and the voltage of the target battery.

For example, the database may include an abnormal graph in which the voltage corresponding to the abnormal state of the battery is represented.

For example, the battery diagnosis method may include an operation of comparing a graph representing the voltage of the target battery with the database. For example, the battery diagnosis method may include an operation of identifying whether the state of the target battery is an abnormal state based on whether the graph representing the voltage of the target battery and the database match.

For example, the battery diagnosis method may include an operation of identifying that the state of the target battery is an abnormal state based on the fact that the graph representing the voltage of the target battery and the database match.

For example, the battery diagnosis method may include an operation of identifying an abnormality type in the state of the target battery based on the fact that the graph representing the voltage of the target battery and the database match.

For example, the battery diagnosis method may include an operation of identifying that the state of the target battery is a normal state based on the fact that the the graph representing the voltage of the target battery and the database do not match.

For example, the battery diagnosis method may include an operation of identifying whether the voltage of a target battery matches the database based on feature points of an abnormal graph contained in the database.

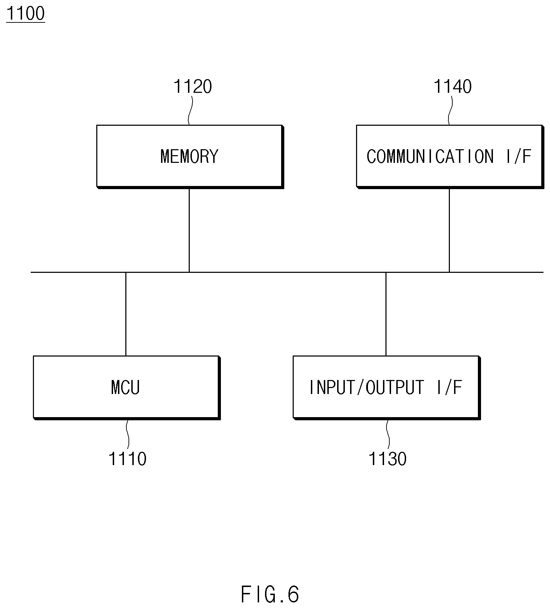

FIG. 6 is a block diagram illustrating a hardware configuration of a computing system that performs a battery diagnosis method, in a battery diagnosis device and battery diagnosis method according to an embodiment of this document.

Referring to FIG. 6, a computing system 1100 according to an embodiment disclosed in this document may include an MCU 1110, a memory 1120, an input/output I/F 1130, and a communication I/F 1140.

The MCU 1110 may be a processor that executes various programs (e.g., battery cell data collection program, graph generation program, data analysis program, data decomposition algorithm, normalization program, and battery cell diagnosis program, etc.) stored in the memory 1220, processes various information including characteristic data of the battery cell, latent variables, etc. through these programs, and performs the functions of the battery diagnosis device 200 shown in FIGS. 1 to 5 described above.

The memory 1120 may store various programs such as the battery cell data collection program, the graph generation program, the data analysis program, the data decomposition algorithm, the normalization program, and the battery cell diagnosis program.

A plurality of such memories 1120 may be provided as needed. The memory 1120 may be a volatile memory or a nonvolatile memory. The memory 1120 used as the volatile memory may be RAM, DRAM, SRAM, etc. The memory 1120 used as the nonvolatile memory may be ROM, PROM, EAROM, EPROM, EEPROM, flash memory, etc. The examples of the memories 1120 listed above are only examples, but are not limited to these examples.

The input/output I/F 1130 may provide an interface that allows data to be transmitted and received by connecting an input device (not shown) such as a keyboard, mouse, or touch panel and an output device (not shown) such as a display with the MCU 1110.

The communication I/F 1140 is a configuration that can transmit and receive various data with the server, and may be various devices that can support wired or wireless communication. For example, the battery diagnosis device 200 may transmit and receive various information including shape models of battery cells, etc. to and from a separately provided external server through the communication I/F 1140.

In this way, the computer program according to an embodiment disclosed in this document may be implemented as a module that performs, for example, each function shown in FIG. 2, by being recorded in the memory 1120 and processed by the MCU 1110.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

## Claims

1. A battery diagnosis device, comprising:
a memory in which one or more instructions are stored; and
a processor configured to execute the one or more instructions,
wherein the processor is configured to:
acquire time series data related to a target battery for a designated duration; and
diagnose a state of the target battery based on a database for diagnosing whether a state of a battery is an abnormal state and the time series data, and
the time series data has a format corresponding to the database.

2. The battery diagnosis device of claim 1, wherein the processor is configured to diagnose the state of the target battery based on a comparison between the database and the time series data.

3. The battery diagnosis device of claim 1, wherein the processor is configured to generate a graph representing at least one of a voltage, a current, a temperature, a resistance, a state of charge (SOC), and a state of health (SOH) of the battery included in the time series data, and any combination thereof, based on identifying the at least one of the voltage, the current, the temperature, the resistance, the SOC, the SOH, and any combination thereof.

4. The battery diagnosis device of claim 3, wherein the processor is configured to diagnose whether the state of the target battery is an abnormal state based on whether the graph and the database match.

5. The battery diagnosis device of claim 4, wherein the processor is configured to identify that the state of the target battery is the abnormal state based on the fact that the graph and the database match.

6. The battery diagnosis device of claim 4, wherein the processor is configured to identify an abnormality type of the state of the target battery based on the fact that the graph and the database match.

7. The battery diagnosis device of claim 4, wherein the processor is configured to identify that the state of the target battery is a normal state based on the fact that the graph and the database do not match.

8. The battery diagnosis device of claim 1, wherein the database includes an abnormal graph in which reference time series data corresponding to an abnormal state of the battery is represented.

9. The battery diagnosis device of claim 8, wherein the processor is configured to identify whether the time series data matches the database based on a feature point of the abnormal graph.

10. The battery diagnosis device of claim 1, wherein the battery includes at least one of a battery cell, a battery pack, a battery module, and any combination thereof.

11. A battery diagnosis method comprising:
an operation of acquiring, by a processor, time series data related to a target battery for a designated duration; and
an operation of diagnosing, by the processor, a state of the target battery based on a database for diagnosing whether a state of a battery is an abnormal state and the time series data,
wherein the time series data has a format corresponding to the database.

12. The battery diagnosis method of claim 11, wherein the battery diagnosis method comprises an operation of diagnosing the state of the target battery based on a comparison between the database and the time series data.

13. The battery diagnosis method of claim 11, wherein the battery diagnosis method comprises an operation of generating a graph representing at least one of a voltage, a current, a temperature, a resistance, a state of charge (SOC), and a state of health (SOH) of the battery included in the time series data, and any combination thereof, based on identifying the at least one of the voltage, the current, the temperature, the resistance, the SOC, the SOH, and any combination thereof.

14. The battery diagnosis method of claim 13, wherein the battery diagnosis method comprises an operation of diagnosing whether the state of the target battery is an abnormal state based on whether the graph and the database match.

15. The battery diagnosis device of claim 14, wherein the battery diagnosis method comprises an operation of identifying that the state of the target battery is the abnormal state based on the fact that the graph and the database match.
